(19) Europäisches Patentamt / European Patent Office / Office européen des brevets

(11) **EP 2 746 785 B1**

(12) **EUROPEAN PATENT SPECIFICATION**

(45) Date of publication and mention
of the grant of the patent:
**01.11.2017 Bulletin 2017/44**

(51) Int Cl.:
*G01R 19/25* [(2006.01)]       *G01R 23/02* [(2006.01)]
*G01R 23/20* [(2006.01)]

(21) Application number: **12306629.2**

(22) Date of filing: **19.12.2012**

(54) **Fundamental frequency stability and harmonic analysis**

Analyse von Grundfrequenzstabilität und Harmonischen

Analyse de la stabilité de fréquence fondamentale et des harmoniques

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**25.06.2014 Bulletin 2014/26**

(73) Proprietor: **Itron Global SARL
Liberty Lake WA 99019 (US)**

(72) Inventors:
• **Chanedeau, Gwladys Fabienne Alice
F-86170 Blaslay (FR)**
• **Gaubert, Jean-Paul
F-86000 Poitiers (FR)**
• **Tissier, Jean-Francois
F-86360 Chasseneuil du Poitou (FR)**

(74) Representative: **Shipp, Nicholas
Kilburn & Strode LLP
Lacon London
84 Theobalds Road
London WC1X 8NL (GB)**

(56) References cited:
WO-A1-2012/013883       US-A- 5 832 413
US-A1- 2009 299 666

• CHANEDEAU G ET AL: "Frequency measurement
with high accuracy and method for harmonics
identification in polluted distribution power
networks", PROCEEDINGS OF THE 2012 IEEE
INTERNATIONAL CONFERENCE ON
INDUSTRIAL TECHNOLOGY (ICIT 2012) IEEE
PISCATAWAY, NJ, USA, 19 March 2012
(2012-03-19), - 21 March 2012 (2012-03-21), pages
474-479, XP55062970, ISBN: 978-1-4673-0340-8
• CARULLO A ET AL: "Power meter for
highly-distorted three-phase systems",
INSTRUMENTATION AND MEASUREMENT
TECHNOLOGY CONFERENCE, 1996. IMTC-96.
CONFERENCE PROCEEEDINGS. QUALITY
MEASUREMENTS: THE INDISPENSABLE BRIDG
E BETWEEN THEORY AND REALITY., IEEE
BRUSSELS, BELGIUM 4-6 JUNE 1996, NEW
YORK, NY, USA,IEEE, US, vol. 2, 4 June 1996
(1996-06-04), pages 939-944, XP010164013, DOI:
10.1109/IMTC.1996.507305 ISBN:
978-0-7803-3312-3

**EP 2 746 785 B1**

## Description

### Field of Invention

This disclosure relates to the field of signal analysis. More specifically, but not exclusively, the disclosure relates to a method and corresponding apparatus for analysing an electrical signal in order to determine a fundamental frequency of the signal along with associated harmonics.

### Background to the Invention

Stability of electricity grids is extremely important because so much of everyday life relies upon a stable and constant supply of electricity. If electricity supplied by an electricity grid is unstable then there is a high risk of a blackout occurring, which in some circumstances can result in large areas of a country, or even continent, losing power for relatively long periods of time. While blackouts are a general annoyance to everyone in a blackout zone, they also have an economic effect on businesses in the blackout zone and beyond.

In order to help maintain a stable electricity grid it is necessary to precisely monitor the electricity being supplied by the electricity grid in order to detect unusual fluctuations in the electricity supply, particularly in the frequency of the supply.

In recent years, electricity grids have started to become far more complex, particularly as more small scale renewable energy power sources are being integrated into electricity grids. Fortunately, new ranges of smart meters may help with such problems because the smart meters themselves are able to monitor certain characteristics of an electricity grid and feed such information back to a central server. Consequently, the central server is provided with more information from more sources, which makes the electricity grid as a whole better placed to keep a track of fluctuations in the electricity supply across the grid.

The resources available on smart meters for performing electricity signal analysis are limited and therefore many algorithms used by HV or MV substations to perform such frequency analysis are not suitable for use in a smart meter.

Simple methods of fundamental frequency estimation using zero crossings are well-known. However, such methods only obtain frequency information and do not obtain valuable information such as signal amplitude, and harmonic content of the electrical signal. Obtaining frequency, amplitude and harmonic information is required for obtaining a detailed understanding of the current state of the grid, throughout the grid. However, obtaining such detailed information to sufficient accuracy levels using the limited resources provided by smart meters is very difficult.

US 5,832,413 discloses a method for estimating phasors and tracking the frequency of a signal during frequency ramping is provided. The method uses a variable N-point DFT periodically to compute one or more phasors based on data acquired from one or more sampled signals. The period between DFT computations is a predetermined number of sample periods. After each DFT computation, the change in phasor angle between the current phasor estimate and the most previous phasor estimate is determined and used to estimate the instantaneous frequency of the signal. The current instantaneous frequency estimate and the most previous instantaneous frequency estimate are averaged to compute an average cycle frequency. In addition, a number of discrete frequencies and corresponding DFT windows based on a fixed sampling rate and a predetermined fundamental frequency of the signal are defined and used in estimating the instantaneous frequency. Once the average cycle frequency is determined the DFT window is adjusted by setting it equal to the DFT window corresponding to the discrete frequency closest to the average cycle frequency.

### Summary of Invention

Embodiments of the present invention attempt to mitigate at least some of the above-mentioned problems.

In accordance with an aspect of the invention there is provided a method for estimating a frequency of an electrical signal, the method comprising taking a number of samples of an electrical signal throughout a main sampling window. The method also comprises dividing the number of samples taken throughout the main sampling window into a plurality of groups of consecutive samples, each group of consecutive samples forming a subwindow, wherein each subwindow includes a minimum number of the number of samples required to provide a required level of accuracy for estimating the fundamental frequency of the electrical signal. In addition, the method comprises estimating, for each subwindow, the fundamental frequency of the electrical signal based on the group of consecutive samples of the respective subwindow. The method also comprises determining if the fundamental frequency is stable throughout the main window by comparing the estimated fundamental frequency of each subwindow.

The method may further comprise determining a size of a main sampling window in terms of a number of samples prior to taking the number of samples.

In addition, the method may further comprise estimating the fundamental frequency over the main window if the fundamental frequency is determined to be stable throughout the main window.

The method may also further comprise performing harmonic analysis on the number of samples if the fundamental frequency is determined to be stable.

Furthermore, the method may further comprise determining a total harmonic distortion associated with the number of samples and re-sampling the electrical signal if the total harmonic distortion exceeds a threshold.

The fundamental frequency may be estimated using a maximum frequency point method. The fundamental frequency may be estimated using the maximum frequency point method in accordance with the following equation:

$$Max[A(1)] = Max \sqrt{a_1^2(F_1) + b_1^2(F_1)}$$

Wherein Max[A(1)] is the maximum magnitude value of fundamental frequency, F1 is the estimated fundamental frequency, and a1 and b1 are the fundamental discrete Fourier coefficients defined by:

$$a_1 = \frac{1}{N_T} \sum_{i=0}^{N-1} \frac{2T_e}{T_1} S(i)\cos(2\pi F_1 \, iT_e)$$

and

$$b_1 = \frac{1}{N_T} \sum_{i=0}^{N-1} \frac{2T_e}{T_1} S(i)\sin(2\pi F_1 \, iT_e)$$

Wherein $T_e$ is the sampling period, N is the total number of samples, $N_T$ is the total number of periods, i is the reference of a sample, and S(i) is a sample of the signal.

The fundamental frequency may be estimated over the main window by using the maximum frequency point method with a starting frequency equal to the average frequency over all the sub-windows.

Each subwindow may comprise approximately 700 samples. The main window may comprise at least 1200 samples. The main window preferably comprises approximately 5000 samples.

According to another aspect of the invention an apparatus is provided that is arranged to implement the method as described herein. The apparatus may be an electricity meter. 4. The electricity meter may further comprise a sensor arranged to take the samples, a memory arranged to store the one or more samples and store a computer program for implementing the method, and a processor arranged to perform the method in accordance with the stored samples and the computer program.

According to yet another aspect of the invention a computer readable medium is provided comprising computer readable code operable, in use, to instruct a computer to perform the method as described herein.

Embodiments of the invention provide a methodology for analysis of electrical signals including an accurate determination of the fundamental frequency of signals over successive sliding windows thereafter authorizing a reliable and significant harmonic analysis over all of the successive sliding windows.

Furthermore, embodiments of the invention provide an algorithmic principle utilizing Maximum Frequency Point (MFP) techniques as disclosed in PCT/FR2011/051575 to certify the stability of the fundamental frequency over a signal sampling window.

In certain embodiments of the invention algorithmic principles are used to decompose global voltage and current waveforms into their harmonic components at electricity meters.

Embodiments of the invention perform harmonic decomposition of electrical waveforms (voltage and current) based on the accurate knowledge of a fundamental frequency of the electrical waveform.

An algorithm is provided by embodiments of the invention that allows for control of the fundamental frequency during a studied window to provide stability both in terms of magnitude and phase. The extraction of the characteristics of the signal, such as magnitude and phase, for each harmonic component is possible with high accuracy. Furthermore, the stability of the magnitude of each harmonic component can also be verified by the algorithm provided in accordance with embodiments of the invention.

Embodiments of the invention provide an algorithm that can be integrated inside firmware of electricity meters. Such algorithms can also be utilized in residential electricity meters having low processing capabilities. The algorithm may be able to be integrated into existing electricity meters without an increase in hardware cost.

In embodiments of the invention, full harmonic analysis on every metrological channel is achievable.

Embodiments of the invention provide a system in which data size can be reduced to a minimum and can be sent to a data centre.

The algorithm according to embodiments of the invention permits an accurate calculation of the fundamental component (frequency, magnitude and phase) and harmonic range (magnitude and phase) throughout the studied window.

Embodiments of the invention allow for a detailed characterization of an electrical signal during a studied window. Some of the information that can be obtained may include one or more of:

1) The fundamental frequency;
2) Stability of the fundamental frequency over a main sampling window;
3) Fundamental rms magnitude and true rms value;
4) Fundamental magnitude state (i.e. stable, not stable);
5) THD values;
6) Selective harmonic analysis (including magnitude and phase);
7) Harmonic components state (i.e. stable, not stable)
8) Synthesis and transmission of pertinent power quality data.

## Brief Description of the Drawings

Exemplary embodiments of the invention shall now be described with reference to the drawings in which:

Figure 1 illustrates a process for estimating characteristics of an electrical signal, including a fundamental frequency and harmonic components;
Figure 2 shows a variation of fundamental frequency over a total duration of a main window comprising 60000 samples at a sampling rate of 256μs; and
Figure 3 shows a variation of the estimated fundamental frequency over subwindows of 10 periods of the fundamental frequency corresponding to 780 samples, wherein 76 subwindows are analyzed over a main window of 15,36s.

Throughout the description and the drawings, like reference numerals refer to like parts.

## Specific Description

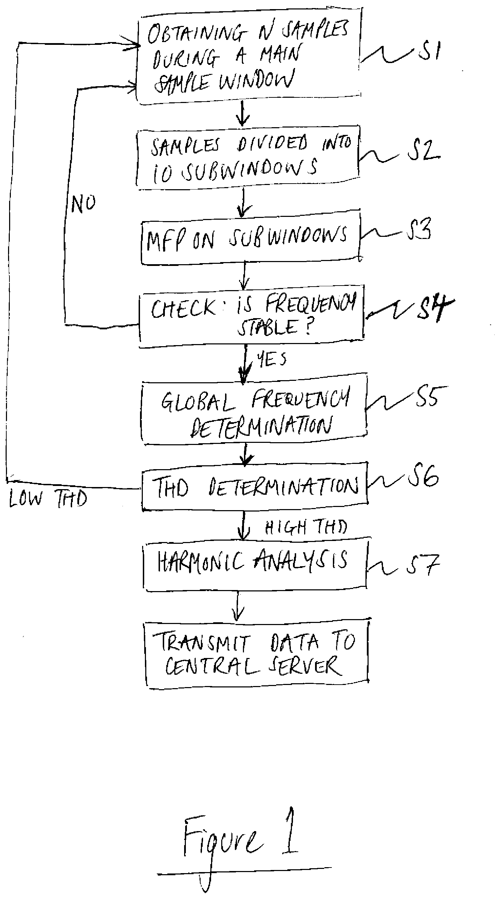

A method, arranged for implantation on a smart meter, for estimating frequency characteristics of an electrical signal, including a fundamental frequency and harmonic components, shall now be described with reference to Figure 1.

At step S1 a number of samples, N, of the electrical characteristics of the signal are taken throughout a main sampling window. The samples may be voltage or current measurements of the electrical signal. Consequently, a suitable sensor within the smart meter is utilized to take the samples. The size of the main window, in terms of number of samples, is selected to balance the advantage of increased accuracy if the window is larger and more samples are therefore taken, with respect to the disadvantage of the additional processing and time required if more samples are taken. The size of the main window is determined by the smart meter; however, it will be appreciated that the size of the main window may be pre-programmed into the smart meter or updated on the smart meter remotely.

Once all of the samples have been taken, the sampled data throughout the main window is divided into a number of successive and adjacent subwindows at step S2. For each subwindow, the fundamental frequency of the signal is estimated using a Maximum Frequency Point (MFP) method as disclosed in PCT/FR2011/051575 and as shown by step S3 and discussed in detail below.

The principle of the MFP method is the calculation of the fundamental discrete Fourier coefficients $a_1$ and $b_1$ of the sampled signal, as shown by Equations 1 and 2 respectively:

$$a_1 = \frac{1}{N_T} \sum_{i=0}^{N-1} \frac{2T_e}{T_1} S(i)\cos(2\pi F_1 iT_e)$$

*Equation 1*

$$b_1 = \frac{1}{N_T} \sum_{i=0}^{N-1} \frac{2T_e}{T_1} S(i)\sin(2\pi F_1 iT_e)$$

*Equation 2*

Wherein $T_e$ is the sampling period, N is the total number of samples, $N_T$ is the total number of periods, i is the reference of a sample, S(i) is a sample of the signal, $F_1$ is the estimated fundamental frequency.

The coefficients $a_1$ and $b_1$ are therefore calculated for each subwindow forming part of the main window. Then from the determined coefficients $a_1$ and $b_1$ of each subwindow the magnitude of the fundamental frequency component for each subwindow can be calculated in accordance with Equation 3:

$$Max[A(1)] = Max \sqrt{a_1^2(F_1) + b_1^2(F_1)}$$

*Equation 3*

Wherein Max[A(1)] is the maximum magnitude value of fundamental frequency, a1 and b1 are the fundamental discrete Fourier coefficients and F1 is the estimated fundamental frequency.

The MFP method enables for estimation of the fundamental frequency at 50Hz or 60Hz with an accuracy of thousandths of hertz for a window of 5000 samples at a sampling period of 256μs. The accuracy of the fundamental frequency estimation depends on the total number of samples associated with the sampling frequency. Hence, over a window of 700 samples an accuracy of thousandths of hertz can be obtained. For example, when F1 = 50Hz and Te = 256μs, a sub-window size of 700 samples is provided, which corresponds to 10 periods of the main frequency. Consequently, a minimum window size of approximately 700 samples equivalent to 10 periods is required in order to provide the required accuracy.

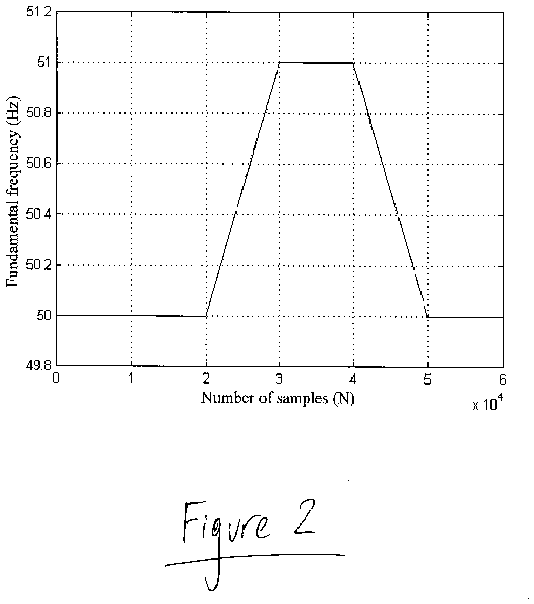

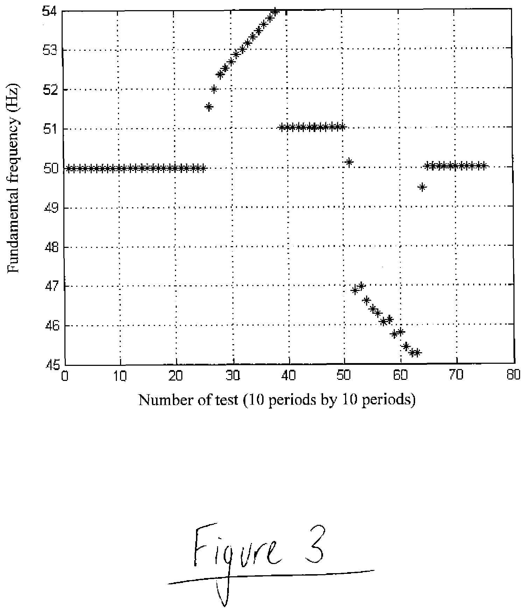

Once all of the samples are taken, it is then determined whether or not the frequency is stable across all of the main window at step S4. If the fundamental frequency estimation is constant over all of the successive subwindows then it is determined that the fundamental frequency is stable throughout the main window with the accuracy of thousandths of hertz. More specifically, the smart meter determines that the frequency is stable if there is not a variation in the frequency of greater than +/-1 mHz over all of the subwindows. If the frequency variation is greater than +/- 1 mHz then it is determined that the fundamental frequency is not stable, the accuracy of the fundamental frequency over the all studied window is not valid, and the analysis is stopped. Consequently, if the frequency is not stable then steps S1 to S3 are repeated again. This process is repeated until it is determined that the fundamental frequency is stable. Figure 2 shows frequency instability over a period of samples during a trapezoidal frequency profile, while Figure 3 shows frequency instability over intervals of 700 samples corresponding to 10 periods of the fundamental frequency.

If the frequency is stable then the global frequency, i.e. the frequency across the whole of the main window is determined at step S5. The fundamental frequency across the whole of the main window is determined by applying the MFP algorithm on all of the samples of the main window, with a starting frequency used for the process equal to the averaging of each subwindow frequency estimation.

Once the fundamental frequency $F_1$ has been proved to be stable over the whole of the studied main window, a Total Harmonic Distortion (THD) of the signal throughout the main sampling window is determined at step S6.

There are two standard definitions for calculating the THD of a periodical waveform, as discussed below.

The ratio between the total harmonic content of the signal during the sampling window and the RMS value of the component at the fundamental frequency as determined during steps S1 to S5 can be calculated in accordance with Equation 4:

$$THD_{(1)} = \frac{\sqrt{\sum_{n=2}^{\infty} X_{rms\,n}^2}}{X_{rms}1} * 100(\%)$$

*Equation 4*

Wherein $X_{rms}1$ is the fundamental component of the signal, and $X_{rms}n$ is the harmonic component of the signal at rank n, its frequency is n x F1.

Furthermore, the ratio between the harmonic content during the window and the true RMS value of the fundamental frequency of the signal as determined during steps S1 to S5 can be calculated in accordance with Equation 5:

$$THD_{(2)} = \frac{\sqrt{\sum_{n=2}^{\infty} X_{rms\,n}^2}}{\sqrt{\sum_{n=1}^{\infty} X_{rms\,n}^2}}$$

*Equation 5*

Equations 4 and 5 are mathematically linked by the relation shown by Equation 6:

$$THD_{(1)} = \frac{THD_{(2)}}{\sqrt{1 - (THD_{(2)}^2)}}$$

*Equation 6*

The calculation of one THD ($THD_{(1)}$ or $THD_{(2)}$) over a signal window is then sufficient to know the two values of THD using equation 6.

If the THD value as defined by either Equation 4 or Equation 5 exceeds a maximum limit value linked to the THD definition, the harmonic analysis at step S7 is performed. The THD limit is set in accordance with the IEC 61000 standard, IEEE 519 (Recommended Practices and Requirements for Harmonic Control in Electric Power systems in the USA). If the THD value as defined by either Equation 4 or Equation 5 exceeds the maximum limit value linked to the THD definition a new sample window capture process can be performed by returning to step S1.

When the THD value exceeds the maximum limit value linked to the THD definition; magnitude and phase of each harmonic range can be calculated at step S7. This is calculated using the Fourier coefficients, $a_h$ and $b_h$, that have already been determined for each sample. Consequently, the discrete Fourier coefficients $a_h$ and $b_h$ at harmonic range h are calculated by Equations 7 and 8:

$$a_h = \frac{1}{N_T} \sum_{i=0}^{N-1} \frac{2T_e}{T_1} S(i) \cos(2\pi h\, F_1\, iT_e)$$

*Equation 7*

Wherein $T_e$ is the sampling period, N is the total number of samples, $N_T$ is the total number of periods, i is the reference of a sample, S(i) is a sample of the signal, h is harmonic range, and $F_1$ is the estimated fundamental frequency.

$$b_h = \frac{1}{N_T} \sum_{i=0}^{N-1} \frac{2T_e}{T_1} S(i) \sin(2\pi h\, F_1\, iT_e)$$

*Equation 8*

Wherein $T_e$ is the sampling period, N is the total number of samples, $N_T$ is the total number of periods, i is the reference of a sample, S(i) is a sample of the signal, h is harmonic range, and $F_1$ is the estimated fundamental frequency.

From the Fourier coefficients, the amplitude of the harmonic components are calculated using Equation 9:

$$A_h = \sqrt{a_h^2 + b_h^2}$$

*Equation 9*

Wherein $A_h$ is the amplitude of the harmonic, $a_h$ and $b_h$ are discrete Fourier coefficient.

Furthermore, the phase of the harmonic components is calculated using Equation 10:

$$\varphi_h = \tan^{-1}\left(\frac{a_h}{b_h}\right)$$

*Equation 10*

Wherein $\varphi_h$ is the phase of the harmonic components $a_h$ and $b_h$ are discrete Fourier coefficient.

The harmonic analysis therefore comprises carrying out the same Fourier analysis used to determine and analyse the fundamental frequency. The harmonic analysis is carried out on all harmonic frequencies that are integer multiples of the fundamental frequency.

At this point, the fundamental frequency along with the phase and amplitude components of the harmonic components have been determined accurately and reliably.

In practice, the above-described method can be implemented on any suitable device on an electricity grid for determining frequency characteristics of an electricity signal on the grid. However, the above-described method is arranged so that it is suitable for being implemented on a smart meter or other device having limited processing capabilities. The smart meters or other devices on the grid system that obtain this information are arranged to transfer the information to a centralized data centre. All such smart meters, or other devices on the network, are arranged to perform their measurements and calculations in accordance with a reference time of the main study window which is $t_0$. Hence, acquisition by a number of smart meters is synchronized in time for all the metrological channels such as voltage and current of the meter. In consequence, all of the components such as the fundamental frequency and harmonic phases are synchronised to the same time reference, $t_0$, within a single meter and across the network.

When a centralized data centre collects information of harmonic content from a number of electricity meters spread across a grid, the data centre is then able to perform harmonic pollution flow analysis. Hence, the collected information can be used by the data centre to monitor the grid in detail. Furthermore, the data centre can then use this information to control the grid by controlling smart meters or even MV/HV substations.

When implemented by a processor on a smart-meter or as a computer program on any type of computer, a computer would be provided having a memory to store the computer program, and a processor to implement the computer program. The processor would then perform the algorithmic process. The computer program may include computer code arranged to instruct a computer to perform the functions of one or more of the various methods described above. The computer program and/or the code for performing such methods may be provided to an apparatus, such as a computer, on a computer readable medium. The computer readable medium could be, for example, an electronic, magnetic, optical, electromagnetic, infrared, or semiconductor system, or a propagation medium for data transmission, for example for downloading the code over the Internet. Non-limiting examples of a physical computer readable medium include semiconductor or solid state memory, magnetic tape, a removable computer diskette, a random access memory (RAM), a read-only memory (ROM), a rigid magnetic disc, and an optical disk, such as a CD-ROM, CD-R/W or DVD.

**Claims**

1. A method for estimating a frequency of an electrical signal, the method comprising:

    taking a number of samples of an electrical signal throughout a main sampling window (S1);
    dividing the number of samples taken throughout the main sampling window into a plurality of groups of consecutive samples (S2), each group of consecutive samples forming a subwindow, wherein each subwindow includes a minimum number of the number of samples required to provide a required level of accuracy for estimating the fundamental frequency of the electrical signal;
    estimating, for each subwindow, the fundamental frequency of the electrical signal based on the group of consecutive samples of the respective subwindow (S3); and
    determining if the fundamental frequency is stable throughout the main window by comparing the estimated fundamental frequency of each subwindow (S4).

2. The method according to 1, further comprising determining a size of a main sampling window in terms of a number of samples prior to taking the number of samples.

3. The method according to claim 1 or claim 2, further comprising estimating the fundamental frequency over the main window if the fundamental frequency is determined to be stable throughout the main window (S5).

4. The method according to any preceding claim, further comprising performing harmonic analysis on the number of samples if the fundamental frequency is determined to be stable (S6).

5. The method according to any preceding claim, further comprising determining a total harmonic distortion associated with the number of samples and resampling the electrical signal if the total harmonic distortion exceeds a threshold (S6).

6. The method according to any preceding claim, wherein the fundamental frequency is estimated using a maximum frequency point method (S3).

7. The method according to claim 6, wherein the fundamental frequency is estimated using the maximum frequency point method in accordance with the following equations:

$$Max[A(1)] = Max \sqrt{a_1^2(F_1) + b_1^2(F_1)}$$

Wherein Max[A(1)] is the maximum magnitude value of fundamental frequency, F1 is the estimated fundamental frequency, and a1 and b1 are the fundamental discrete Fourier coefficients defined by:

$$a_1 = \frac{1}{N_T} \sum_{i=0}^{N-1} \frac{2T_e}{T_1} S(i)\cos(2\pi F_1 iT_e)$$

and

$$b_1 = \frac{1}{N_T} \sum_{i=0}^{N-1} \frac{2T_e}{T_1} S(i)\sin(2\pi F_1 iT_e)$$

Wherein $T_e$ is the sampling period, N is the total number of samples, $N_T$ is the total number of periods, i is the reference of a sample, and S(i) is a sample of the signal.

8. The method according to claim 3, wherein the fundamental frequency is estimated over the main window by using the maximum frequency point method with a starting frequency equal to the average frequency over all the sub-windows.

9. The method according to any preceding claim, wherein each subwindow comprises approximately 700 samples.

10. The method according to any preceding claim, wherein the main window comprises at least 1200 samples.

11. The method according to any preceding claim, wherein the main window comprises approximately 5000 samples.

12. Apparatus for estimating a frequency of an electrical signal, the apparatus arranged to implement the method of any preceding claim.

13. The apparatus according to claim 12, wherein the apparatus is an electricity meter.

14. The apparatus according to claim 13, wherein the electricity meter further comprises:

a sensor arranged to take the samples;
a memory arranged to store the one or more samples and store a computer program for implementing the method; and
a processor arranged to perform the method in accordance with the stored samples and the computer program.

15. A computer readable medium comprising computer readable code operable, in use, to instruct a computer to perform all the steps of the method of any one of claims 1 to 11.

**Patentansprüche**

1. Verfahren zum Schätzen einer Frequenz eines elektrischen Signals, wobei das Verfahren die folgenden Schritte umfasst:

Aufnehmen einer Anzahl von Abtastungen eines elektrischen Signals über ein Hauptabtastfenster hinweg (S1);
Aufteilen der Anzahl von Abtastungen, die über das Hauptabtastfenster hinweg aufgenommen wurden, in eine Vielzahl von Gruppen von aufeinanderfolgenden Abtastungen (S2), wobei jede Gruppe von aufeinanderfolgenden Abtastungen ein Unterfenster bildet, wobei jedes Unterfenster eine Minimalanzahl der Anzahl von Abtastungen enthält, die erforderlich ist, um einen erforderlichen Genauigkeitsgrad für das Schätzen der Grundfrequenz des elektrischen Signals zu erzielen;
Schätzen, für jedes Unterfenster, der Grundfrequenz des elektrischen Signals auf der Grundlage der Gruppe von aufeinanderfolgenden Abtastungen des jeweiligen Unterfensters (S3); und
Bestimmen, ob die Grundfrequenz über das Hauptfenster hinweg stabil ist, durch Vergleichen der geschätzten Grundfrequenz jedes Unterfensters (S4).

**2.** Verfahren nach Anspruch 1, das ferner Bestimmen einer Größe eines Hauptabtastfensters hinsichtlich einer Anzahl von Abtastungen vor dem Aufnehmen der Anzahl von Abtastungen umfasst.

**3.** Verfahren nach Anspruch 1 oder Anspruch 2, das ferner Schätzen der Grundfrequenz über das Hauptfenster hinweg, wenn die Grundfrequenz als über das Hauptfenster hinweg stabil bestimmt wird (S5), umfasst.

**4.** Verfahren nach einem der vorhergehenden Ansprüche, das ferner Durchführen von Harmonischenanalyse an der Anzahl von Abtastungen, falls die Grundfrequenz als stabil bestimmt wird (S6), umfasst.

**5.** Verfahren nach einem der vorhergehenden Ansprüche, ferner umfassend Bestimmen einer harmonischen Gesamtverzerrung, die mit der Anzahl von Abtastungen und Neuabtastung des elektrischen Signals assoziiert ist, wenn die harmonische Gesamtverzerrung eine Schwelle übersteigt (S6).

**6.** Verfahren nach einem der vorhergehenden Ansprüche, wobei die Grundfrequenz unter Verwendung eines Maximalfrequenzpunktverfahrens geschätzt wird (S3).

**7.** Verfahren nach Anspruch 6, wobei die Grundfrequenz unter Verwendung des Maximalfrequenzpunktverfahrens gemäß den folgenden Gleichungen geschätzt wird:

$$Max[A(1)] = Max\sqrt{a_1^2(F_1) + b_1^2(F_1)}$$

wobei Max[A(1)] der maximale Größenwert der Grundfrequenz ist, F1 die geschätzte Grundfrequenz ist und a1 und b1 folgendermaßen definierte Grund-Diskrete-Fourier-Koeffizienten sind:

$$a_1 = \frac{1}{N_T}\sum_{i=0}^{N-1}\frac{2T_e}{T_1}S(i)\cos(2\pi F_1 i T_e),$$

und

$$b_1 = \frac{1}{N_T}\sum_{i=0}^{N-1}\frac{2T_e}{T_1}S(i)\sin(2\pi F_1 i T_e),$$

wobei $T_e$ die Abtastperiode ist, N die Gesamtanzahl von Abtastungen ist, $N_T$ die Gesamtanzahl von Perioden ist, i die Referenznummer einer Abtastung ist und S(i) eine Abtastung des Signals ist.

**8.** Verfahren nach Anspruch 3, wobei die Grundfrequenz unter Verwendung des Maximalfrequenzpunktverfahrens mit einer Startfrequenz gleich der mittleren Frequenz über alle Unterfenster hinweg über dem Hauptfenster geschätzt wird.

**9.** Verfahren nach einem der vorhergehenden Ansprüche, wobei jedes Unterfenster ungefähr 700 Abtastungen umfasst.

**10.** Verfahren nach einem der vorhergehenden Ansprüche, wobei das Hauptfenster mindestens 1200 Abtastungen umfasst.

**11.** Verfahren nach einem der vorhergehenden Ansprüche, wobei das Hauptfenster ungefähr 5000 Abtastungen umfasst.

**12.** Vorrichtung zum Schätzen einer Frequenz eines elektrischen Signals, wobei die Vorrichtung ausgelegt ist zum Implementieren des Verfahrens nach einem der vorhergehenden Ansprüche.

**13.** Vorrichtung nach Anspruch 12, wobei die Vorrichtung ein Stromzähler ist.

**14.** Vorrichtung nach Anspruch 13, wobei der Stromzähler ferner Folgendes umfasst:

einen Sensor, der ausgelegt ist zum Aufnehmen der Abtastungen;
einen Speicher, der ausgelegt ist zum Speichern einer oder mehrerer Abtastungen und zum Speichern eines Computerprogramms zum Implementieren des Verfahrens; und
einen Prozessor, der ausgelegt ist zum Durchführen des Verfahrens gemäß den gespeicherten Abtastungen und dem Computerprogramm.

**15.** Computerlesbares Medium, das computerlesbaren Code umfasst, der betreibbar ist, bei Gebrauch einen Computer anzuweisen, alle Schritte des Verfahrens nach einem der Ansprüche 1 bis 11 durchzuführen.

**Revendications**

**1.** Procédé pour estimer une fréquence d'un signal électrique, lequel procédé consiste à :

prendre un certain nombre d'échantillons d'un signal électrique dans toute une fenêtre d'échantillonnage principale (S1) ;
diviser le nombre d'échantillons pris dans toute la fenêtre d'échantillonnage principale en plusieurs groupes d'échantillons consécutifs (S2), chaque groupe d'échantillons consécutifs formant une sous-fenêtre, dans lequel chaque sous-fenêtre comprend un nombre minimal d'échantillons nécessaires pour fournir un niveau de précision requis pour estimer la fréquence fondamentale du signal électrique ;
estimer, pour chaque sous-fenêtre, la fréquence fondamentale du signal électrique en fonction du groupe d'échantillons consécutifs dans la sous-fenêtre respective (S3) ; et
déterminer si la fréquence fondamentale est stable dans toute la fenêtre principale en comparant la fréquence fondamentale estimée de chaque sous-fenêtre (S4).

2. Procédé selon la revendication 1, consistant en outre à déterminer une taille d'une fenêtre d'échantillonnage principale en termes de nombre d'échantillons avant de prendre le nombre d'échantillons.

3. Procédé selon la revendication 1 ou la revendication 2, consistant en outre à estimer la fréquence fondamentale sur la fenêtre principale si la fréquence fondamentale est déterminée comme état stable dans toute la fenêtre principale (S5).

4. Procédé selon l'une quelconque des revendications précédentes, consistant en outre à effectuer une analyse harmonique sur le nombre d'échantillons si la fréquence fondamentale est déterminée comme étant stable (S6).

5. Procédé selon l'une quelconque des revendications précédentes, consistant en outre à déterminer une distorsion harmonique totale associée au nombre d'échantillons et à ré-échantillonner le signal électrique si la distorsion harmonique totale dépasse un seuil (S6).

6. Procédé selon l'une quelconque des revendications précédentes, dans lequel la fréquence fondamentale est estimée en utilisant un procédé de point de fréquence maximale (S3).

7. Procédé selon la revendication 6, dans lequel la fréquence fondamentale est estimée en utilisant un procédé de point de fréquence maximale en fonction des équations suivantes :

$$Max[A(1)] = Max\sqrt{a_1^2(F_1) + b_1^2(F_1)}$$

où Max[A(1)] est la valeur de magnitude maximale de la fréquence fondamentale, F1 est la fréquence fondamentale estimée, et a1 et b1 sont des coefficients de Fourier discrets fondamentaux définis par :

$$a_1 = \frac{1}{N_T}\sum_{i=0}^{N-1}\frac{2T_e}{T_1}S(i)\cos(2\pi F_1 \, iT_e)$$

et

$$b_1 = \frac{1}{N_T}\sum_{i=0}^{N-1}\frac{2T_e}{T_1}S(i)\sin(2\pi F_1 \, iT_e)$$

et

où $T_e$ est la période d'échantillonnage, N est le nombre total d'échantillons, $N_T$ est le nombre total de périodes, i est la référence d'un échantillon, et S(i) est un échantillon du signal.

8. Procédé selon la revendication 3, dans lequel la fréquence fondamentale est estimée sur la fenêtre principale en utilisant un procédé de point de fréquence maximale avec une fréquence de départ égale à la fréquence moyenne sur toutes les sous-fenêtres.

9. Procédé selon l'une quelconque des revendications précédentes, dans lequel chaque sous-fenêtre comprend environ 700 échantillons.

10. Procédé selon l'une quelconque des revendications précédentes, dans lequel la fenêtre principale comprend au moins 1200 échantillons.

11. Procédé selon l'une quelconque des revendications précédentes, dans lequel la fenêtre principale comprend environ 5000 échantillons.

12. Appareil pour estimer une fréquence d'un signal électrique, lequel appareil est conçu pour mettre en oeuvre le procédé selon l'une quelconque des revendications précédentes.

13. Appareil selon la revendication 12, lequel appareil est un compteur d'électricité.

14. Appareil selon la revendication 13, dans lequel le compteur d'électricité comprend en outre :

un capteur conçu pour prendre des échantillons ;
une mémoire conçue pour stocker un ou plusieurs échantillons et stocker un programme informatique pour mettre en oeuvre le procédé ; et
un processeur conçu pour réaliser le procédé en fonction des échantillons stockés et du programme informatique.

15. Support lisible par ordinateur comprenant un code lisible par ordinateur qui va, lors de l'utilisation, ordonner à un ordinateur d'effectuer toutes les étapes du procédé selon l'une quelconque des revendications 1 à 11.

OBTAINING N SAMPLES DURING A MAIN SAMPLE WINDOW — S1

SAMPLES DIVIDED INTO 10 SUBWINDOWS — S2

MFP ON SUBWINDOWS — S3

CHECK: IS FREQUENCY STABLE? — S4

NO

YES

GLOBAL FREQUENCY DETERMINATION — S5

THD DETERMINATION — S6

LOW THD

HIGH THD

HARMONIC ANALYSIS — S7

TRANSMIT DATA TO CENTRAL SERVER

Figure 1

Figure 2

Figure 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5832413 A

- FR 2011051575 W